# EUROPÄISCHE PATENTSCHRIFT

(11) **EP 1 719 397 B1**
(45) Veröffentlichungstag und Bekanntmachung des Hinweises auf die Patenterteilung: **11.07.2007**
(21) Anmeldenummer: 04798024.8
(22) Anmeldetag: 20.11.2004
(51) Int. Cl.: H05K 7/20, H01L 23/473, G06F 1/18, G06F 1/20

(54) **GEHÄUSEANORDNUNG**
HOUSING ARRANGEMENT
ENSEMBLE BOITIER

(30) Priorität: 17.02.2004 DE 102004008461
(43) Veröffentlichungstag der Anmeldung: 08.11.2006
(73) Patentinhaber: Rittal GmbH & Co. KG, 35745 Herborn (DE)
(72) Erfinder: DÖRRICH, Martin, 35764 Sinn (DE); NICOLAI, Michael, 35466 Rabenau (DE)
(74) Vertreter: Fleck, Hermann-Joseph
(86) Internationale Anmeldenummer: PCT/EP2004/013199
(87) Internationale Veröffentlichungsnummer: WO 2005/081604

(56) Entgegenhaltungen:
- EP-A- 0 767 601
- WO-A-03/077625
- DE-A1- 10 112 389
- US-A1- 2002 007 641
- US-A1- 2002 021 557

## Beschreibung

Die Erfindung betrifft eine Gehäuseanordnung mit einem Aufnahmegehäuse in dessen Innenraum eine Kühlanordnung und eine oder mehrere elektrische Einheiten aufgenommen sind, wobei die Kühlanordnung eine sich zwischen dem Bodenbereich und dem Deckenbereich des Aufnahmegehäuses zumindest bereichsweise erstreckende Vor- und eine Rücklaufleitung aufweist, wobei von der Vor- und der Rücklaufleitung Verbindungsleitungen abgehen und zumindest einem zwischen den elektrischen Einheiten angeordneten Verteiler führen, an dessen Verteileranschlüssen Anschlussleitungen zu den elektrischen Einheiten anschließbar sind.

Eine Gehäuseanordnung dieser Art ist durch die US 2002/021557 A1 bekannt. Dabei ist durch die Führung der Vor- und Rücklaufleitung zu der Kühlanordnung und der Verbindungsleitung zum Verteiler sowie der Einbauanordnung des Verteilers und elektrischen Einheiten eine unübersichtliche und schwer zugängliche Leitungsführung gegeben, die die Einbau- und Erweiterungsmöglichkeit stark beeinträchtigt.

Es ist Aufgabe der Erfindung, bei einer Gehäuseanordnung dieser Art, diese Nachteile durch eine neue Leitungsführung und Anordnung der Teile so zu vereinfachen, dass durch eine Verbesserung der Zugänglichkeit die Wartungs- und Montagemöglichkeiten erleichtert werden.

Diese Aufgabe wird nach der Erfindung dadurch gelöst, dass der Verteiler im Bereich der Frontseite des Aufnahmegehäuses gehalten ist und die Anschlussleitungen über eine frontseitige Öffnung mit Tür im Aufnahmegehäuse zugänglich sind, dass die als Steigleitungen ausgebildete Vor- und Rücklaufleitung im rückseitigen Bereich des Aufnahmegehäuses angeordnet sind, und dass die Verteilerleitungen zwischen dem Verteiler und den Steigleitungen in Richtung.der Gehäusetiefe verlaufen.

Auf diese Weise sind die Leitungen auf die Rückseite und Vorderseite des Aufnahmegehäuses verlagert und gut zugänglich. Dabei erlaubt die mit einer Tür verschlossene frontseitige Öffnung den Zugang zum Verteiler und dessen Anschlussleitungen, so dass die Anschlussleitungen zu den elektrischen Einheiten bequem geändert werden können. Dies ist besonders im Wartungs- und Erweiterungsfall von Vorteil.

Wenn vorgesehen ist, dass die Verteilerleitungen zwischen dem Verteiler und der Vor- und Rücklaufleitung mit Gefälle verlegt sind, wobei die Verteilerleitungen in Richtung auf die Vor- und Rücklaufleitung ansteigen, dann können die Verteilerleitungen auf einfache Weise über die Vor- und Rücklaufleitung entlüftet werden.

Besonders vorteilhaft ist auch eine Anordnung, bei der vorgesehen ist, dass zumindest ein Teil der elektrischen Einheiten, die an dem Verteiler angekoppelt sind, in Schwerkraftrichtung unterhalb des Verteilers angeordnet sind. Die Kühlkreisläufe der elektrischen Einheiten sind dann über die Verteilerleitungen entlüftbar.

Wenn vorgesehen ist, dass der Verteiler als Hohlprofil mit zwei der Vor- und der Rücklaufleitung zugeordneten Kammern ausgebildet ist, oder dass der Verteiler zwei getrennte Hohlprofilabschnitte aufweist, die der Vor- und der Rücklaufleitung zugeordnet sind, dann werden auf einfache Weise stabile Anschlußmöglichkeiten für die Anschlußleitungen geschaffen. Zum anderen lassen sich die Verteiler einfach verbauen und montieren. Darüber hinaus ist die Leckagegefahr bei solchen Verteilern gering.

Eine denkbare Anwendung der Erfindung kann dadurch gekennzeichnet sein, dass die elektrische Einheit als Computer-Recheneinheit, insbesondere als Powerbladeeinschub ausgebildet ist, der zusammen mit anderen Computer-Recheneinheiten in einen Server, insbesondere einen Bladeserver eingebaut ist. Vor allem Bladeserver zeichnen sich durch eine hohe Verlustleistung aus. Die Erfindung ermöglicht es diese effektiv abzuführen, so dass eine gute Raumausnutzung des Innenraumes des Aufnahmegehäuses möglich wird.

Um die Kühleinrichtung vom Anwender mit geringem Aufwand individuell installieren zu können, kann es vorgesehen sein, dass die Anschlußleitungen über tropffrei füg- und trennbare Kupplungen an die Verteileranschlüsse anfügbar sind und/oder, dass die Verteilerleitungen über tropffreie füg- und trennbare Kupplungen an die Vor- und Rücklaufleitung anfügbar sind.

Die Erfindung wird im folgenden anhand eines in den Zeichnungen dargestellten Ausführungsbeispieles näher erläutert. Es zeigen:
- Fig. 1: in schematischer Darstellung ein Aufnahmegehäuse mit elektrischen Einheiten und einer Kühlanordnung und
- Fig. 2: eine der Fig. 1 entnommene Detaildarstellung.

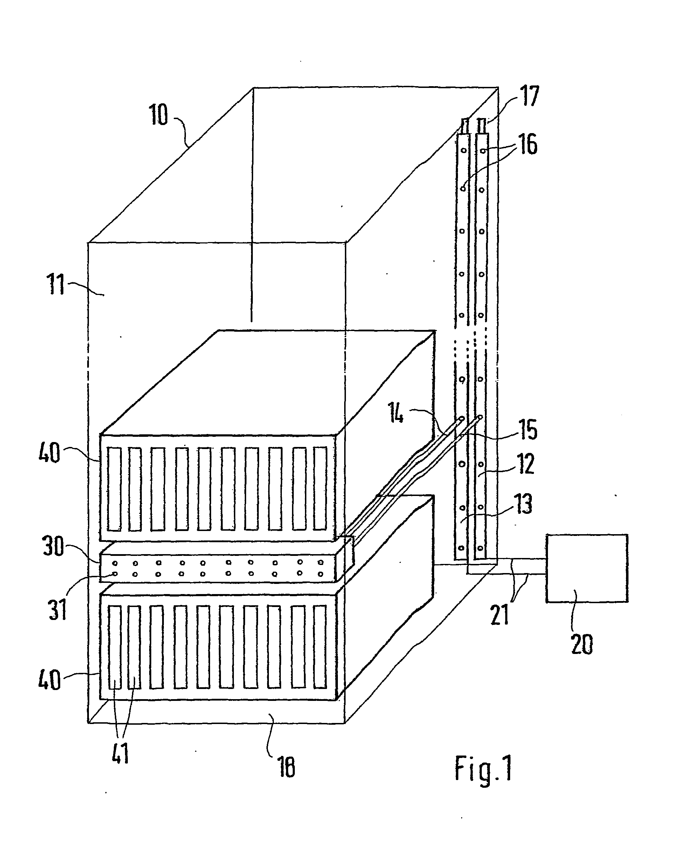

Fig. 1 zeigt ein Aufnahmegehäuse 10, das einen Innenraum 11 umgibt. Derartige Aufnahmegehäuse 10 sind meist als Schaltschränke ausgebildet, die ein Rahmengestell aufweisen. Das Rahmengestell ist allseitig verkleidet und frontseitig (Front 18) mit einer anscharnierten Tür verschlossen. Im Innenraum 11 sind Einbauten am Rahmengestell befestigt. Vorliegend sind als Einbauten Server 40, insbesondere Bladeserver im Innenraum gehalten. Diese weisen Aufnahmen auf, in die vertikal ausgerichtete Rechnereinheiten 41 (Powerbladeeinschübe) einsetzbar sind. Zwischen den Servern 40 ist ein Verteiler 30 angeordnet. Dieser ist als Hohlprofil mit zwei in Längsrichtungen verlaufenden Kammern ausgestattet. Der Verteiler 30 ist ebenso wie der Server 40 durch die geöffnete Front 18 des Aufnahmegehäuses 10 zugänglich. Der Verteiler 30 kann auch am Rahmengestell befestigt werden und überbrückt vollständig oder teilweise die Front 18.

Der Verteiler 30 ist in Längsrichtung mit im Teilungsraster zueinander beabstandet angeordneten Verteileranschlüssen 31 ausgestattet. Diese stehen in Verbindung mit den vom Verteiler 30 gebildeten Kanälen.

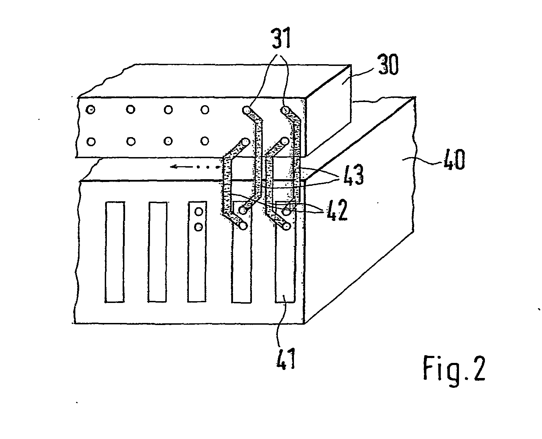

Wie die Fig. 2 zeigt, können an die Verteileranschlüsse 31 Anschlußleitungen 42,43 über tropffrei füg- und trennbare Kupplungen angeschlossen werden. Diese Anschlußleitungen 42,43 sind paarweise zu je einer Rechnereinheit 41 geführt und dort über Anschlüsse 42 ebenfalls tropffrei füg- und trennbar an einen rechnerinteren Kühlkreis angeschlossen.

Wie die Fig. 1 weiter zeigt, ist der Verteiler 30 über zwei Verteilerleitungen 14,15 an zwei Steigleitungen angeschlossen. Diese dienen als Vor- und Rücklaufleitung 12 und 13. Sie sind im Bereich der Rückseite des Schaltschrankes angeordnet und als starre Hohlprofile ausgebildet. Sie weisen im Teilungsraster zu einander beabstandet angeordnete Anschlußstellen auf, an denen die Verteilerleitungen 14,15 über tropffrei füg- und trennbare Kupplungen angeschlossen sind.

Die Vor- und Rücklaufleitungen 12 und 13 können bodenseitig mittels Verbindungsleitungen 21 an eine außerhalb des Aufnahmegehäuses 10 aufgestellte Kühlanlage 20 angeschlossen werden. Im Dachbereich des Aunfahmegehäuses 10 weisen die Vor- und Rücklaufleitungen 12 und 13 Entlüftungen 17 auf. Über diese kann das Kühlsystem entlüftet werden.

Während des Kühlbetriebes stellt die Kühlanlage 20 ein Kühlmedium zur Verfügung, das durch eine der beiden Verbindungsleitungen 21 der Vorlaufleitung 12 zugefördert wird. Von dort gelangt es über die zugeordnete Verteilungsleitung 14 und die Anschlußleitung 43 in das Kühlsystem der jeweiligen Rechnereinheit 41. Darin erwärmt es sich und wird über die Anschlußleitung 42, den Verteiler 30, die Verteilerleitung 15 und die Rücklaufleitung 13 wieder in die Kühlanlage 20 zurückgeführt. Hier wird es gekühlt und erneut eingespeist.

## Patentansprüche

1. Gehäuseanordnung mit einem Aufnahmegehäuse in dessen Innenraum eine Kühlanordnung und eine oder mehrere elektrische Einheiten aufgenommen sind, wobei die Kühlanordnung eine sich zwischen dem Bodenbereich und dem Deckenbereich des Aufnahmegehäuses zumindest bereichsweise erstreckende Vor- und eine Rücklaufleitung aufweist, wobei von der Vor- und der Rücklaufleitung Verbindungsleitungen abgehen und zumindest einem zwischen den elektrischen Einheiten angeordneten Verteiler führen, an dessen Verteileranschlüssen Anschlussleitungen zu den elektrischen Einheiten anschließbar sind,
**dadurch gekennzeichnet,**
**dass** der Verteiler (30) im Bereich der Frontseite (18) des Aufnahmegehäuses (10) gehalten ist und die Anschlussleitungen (42,43) über eine frontseitige Öffnung mit Tür im Aufnahmegehäuse (10) zugänglich sind,
**dass** die als Steigleitungen ausgebildete Vor- und Rücklaufleitung (12,13) im rückseitigen Bereich des Aufnahmegehäuses (10) angeordnet sind, und
**dass** die Verteilerleitungen (14,15) zwischen dem Verteiler (30) und den Steigleitungen in Richtung der Gehäusetiefe verlaufen.

2. Gehäuseanordnung nach Anspruch 1,
**dadurch gekennzeichnet,**
**dass** die Verteilerleitungen (14,15) zwischen dem Verteiler (30) und der Vor- bzw. Rücklaufleitung (12,13) mit Gefälle verlegt sind, wobei die Verteilerleitungen (14,15) in Richtung auf die Vor- und Rücklaufleitung ansteigen.

3. Gehäuseanordnung nach Anspruch 1 oder 2,
**dadurch gekennzeichnet,**
**dass** zumindest ein Teil der elektrischen Einheiten, die an dem Verteiler (30) angekoppelt sind, in Schwerkraftrichtung unterhalb des Verteilers (30) angeordnet sind.

4. Gehäuseanordnung nach einem der Ansprüche 1 bis 3,
**dadurch gekennzeichnet,**
**dass** der Verteiler (30) als Hohlprofil mit zwei der Vor- und der Rücklaufleitung (12,13) zugeordneten Kammern ausgebildet ist, oder
**dass** der Verteiler (30) zwei getrennte Hohlprofilabschnitte aufweist, die der Vor- und der Rücklaufleitung (12,13) zugeordnet sind.

5. Gehäuseanordnung nach einem der Ansprüche 1 bis 4,
**dadurch gekennzeichnet,**
**dass** die elektrische Einheit als Computer-Recheneinheit, insbesondere als Powerbladeeinschub ausgebildet ist, der zusammen mit anderen Computer-Recheneinheiten in einen Server (10), insbesondere einen Bladeserver eingebaut ist.

6. Gehäuseandordnung nach einem der Ansprüche 1 bis 5,
**dadurch gekennzeichnet,**
**dass** die Anschlussleitungen (42,43) über tropffrei füg- und trennbare Kupplungen an die Verteileranschlüsse (31) anfügbar sind und/oder,
**dass** die Verteilerleitungen (14,15) über tropffreie füg- und trennbare Kupplungen an die Vor- und Rücklaufleitung (12,13) anfügbar sind.

## Claims

1. Housing arrangement having an accommodating housing whose interior accommodates a cooling arrangement and one or more electrical units, with the cooling arrangement having a feed line, of which at least some regions extend between the base region and the ceiling region of the accommodating housing, and a return line, with connecting lines branching off from the feed line and the return line and leading to at least one distributor which is arranged between the electrical units and to whose distributor connections connection lines leading to the electrical units can be connected,
**characterized**
**in that** the distributor (30) is held in the region of the front face (18) of the accommodating housing (10), and the connection lines (42, 43) are accessible via a front opening with a door in the accommodating housing (10),
**in that** the feed and return lines (12, 13), which are in the form of riser lines, are arranged in the rear region of the accommodating housing (10), and
**in that** the distributor lines (14, 15) run between the distributor (30) and the riser lines in the direction of the housing depth.

2. Housing arrangement according to Claim 1,
**characterized**
**in that** the distributor lines (14, 15) are laid between the distributor (30) and the feed and return lines (12, 13) with a gradient, with the distributor lines (14, 15) rising in the direction of the feed and return lines.

3. Housing arrangement according to Claim 1 or 2,
**characterized**
**in that** at least some of the electrical units which are coupled to the distributor (30) are arranged beneath the distributor (30) in the direction of gravity.

4. Housing arrangement according to one of Claims 1 to 3,
**characterized**
**in that** the distributor (30) is in the form of a hollow profile with two chambers associated with the feed line (12) and the return line (13), or
**in that** the distributor (30) has two separate hollow profile sections which are associated with the feed line (12) and the return line (13).

5. Housing arrangement according to one of Claims 1 to 4,
**characterized**
**in that** the electrical unit is in the form of a computer processor unit, in particular in the form of a Powerblade insert which is installed, together with other computer processor units, in a server (10), in particular a blade server.

6. Housing arrangement according to one of Claims 1 to 5,
**characterized**
**in that** the connection lines (42, 43) can be attached to the distributor connections (31) via couplings which can be joined and separated in a leaktight manner, and/or
**in that** the distributor lines (14, 15) can be attached to the feed and return lines (12, 13) via couplings which can be joined and separated in a leaktight manner.

## Revendications

1. Ensemble de boîtier avec un boîtier de réception dans l'espace intérieur duquel un dispositif de refroidissement et une ou plusieurs unités électriques sont logés, dans lequel le dispositif de refroidissement comprend une conduite d'arrivée et une conduite de retour s'étendant au moins localement entre la zone de fond et la zone de plafond du boîtier de réception, dans lequel des conduites de raccordement partent de la conduite d'arrivée et de la conduite de retour et conduisent au moins à un distributeur disposé entre les unités électriques, aux raccords de distribution duquel des conduites de raccordement vers les unités électriques peuvent être raccordées, **caractérisé en ce que** le distributeur (30) est maintenu dans la région de la face avant (18) du boîtier de réception (10) et les conduites de raccordement (42, 43) sont accessibles par une ouverture frontale avec une porte dans le boîtier de réception (10), **en ce que** la conduite d'arrivée et la conduite de retour (12, 13) formées par des conduites montantes sont disposées dans la région arrière du boîtier de réception (10), et **en ce que** les conduites du distributeur (14, 15) entre le distributeur (30) et les conduites montantes sont orientées en direction de la profondeur du boîtier.

2. Ensemble de boîtier selon la revendication 1, **caractérisé en ce que** les conduites du distributeur (14, 15) sont posées avec une pente entre le distributeur (30) et la conduite d'arrivée ou la conduite de retour (12, 13), dans lequel les conduites du distributeur (14, 15) montent en direction de la conduite d'arrivée et de la conduite de retour.

3. Ensemble de boîtier selon la revendication 1 ou 2, **caractérisé en ce qu'**au moins une partie des unités électriques, qui sont raccordées au distributeur (30), sont disposées dans le sens de la pesanteur en dessous du distributeur (30).

4. Ensemble de boîtier selon l'une quelconque des revendications 1 à 3, **caractérisé en ce que** le distributeur (30) est formé par un profilé creux avec deux chambres associées à la conduite d'arrivée et à la conduite de retour (12, 13), ou **en ce que** le distributeur (30) comporte deux segments de profilé creux séparés, qui sont associés à la conduite d'arrivée et à la conduite de retour (12, 13).

5. Ensemble de boîtier selon l'une quelconque des revendications 1 à 4, **caractérisé en ce que** l'unité électrique est formée par une unité de calcul par ordinateur, en particulier par un tiroir lame de puissance, qui est monté avec d'autres unités de calcul par ordinateur dans un serveur (10), en particulier un serveur lame.

6. Ensemble de boîtier selon l'une quelconque des revendications 1 à 5, **caractérisé en ce que** les conduites de raccordement (42, 43) peuvent être reliées aux raccords du distributeur (31) par des raccords à assembler et séparer sans gouttes, et/ou **en ce que** les conduites du distributeur (14, 15) peuvent être reliées de manière étanche à la conduite d'arrivée et à la conduite de retour (12, 13) par des raccords à assembler et séparer.
